(19) Europäisches Patentamt
European Patent Office
Office européen des brevets

(11) Publication number: **0 157 541**
**A2**

(12) **EUROPEAN PATENT APPLICATION**

(21) Application number: **85301940.4**

(22) Date of filing: **20.03.85**

(51) Int. Cl.⁴: **G 01 L 9/12**

(30) Priority: **27.03.84 GB 8407848**

(43) Date of publication of application: **09.10.85**
**Bulletin 85/41**

(84) Designated Contracting States: **DE FR GB SE**

(71) Applicant: **EMI Limited, Blyth Road, Hayes Middlesex, UB3 1BP (GB)**

(72) Inventor: **Kember, Peter Nicholas, 39, Haslemere Avenue, Ealing London, W13 9UH (GB)**
Inventor: **Pedley, Derek George, 61, First Avenue, Amersham Buckinghamshire (GB)**
Inventor: **Webb, Brian Christopher, 55, Sunmead Road, Sunbury-on-Thames Middlesex, TW16, 6PE (GB)**

(74) Representative: **Marsh, Robin Geoffrey, Thorn EMI Patents Limited The Quadrangle Westmount Centre Uxbridge Road, Hayes Middlesex, UB4 0HB (GB)**

(54) **Sensor.**

(57) A solid state transducer comprises a FET with a layer (3) of an elastomeric dielectric material between the gate electrode (4) and the gate insulator (2). The layer (3) allows a change in the spacing of the gate electrode and the gate insulator, in response to pressure applied to the device, resulting in a detectable change in their capacitance. The transducer may be used in a sensor (10) suitable for use in article-handling machinery. The sensor includes array of transducers and control circuits to process information signals derived by the transducers.

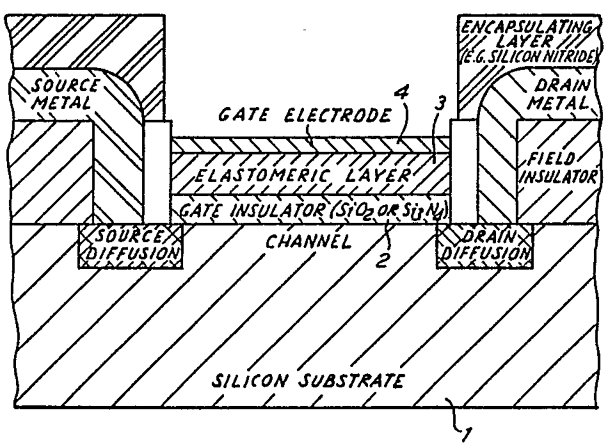

# SENSOR

The present invention relates to a transducer, and a sensor incorporating such transducers, for use in article-handling machinery and especially, but not solely, suited for use in programmable manipulators.

According to one aspect, the present invention provides a solid-state transducer comprising a field-effect transistor device wherein a layer of an elastomeric dielectric material lies between respective electrode layers of the device, whereby the layer of the elastomeric dielectric material allows a change in the spacing of the electrode layers in response to pressure applied to the device, thereby causing a detectable change in the capacitance of the electrode layers.

In one preferred embodiment, the elastomeric dielectric layer is situated intermediate and adjacent an electrode layer and a gate electrode layer of a field-effect transistor device. In an alternative preferred embodiment, the elastomeric dielectric layer is situated intermediate and adjacent an electrode layer and a floating gate electrode, whereby the floating gate electrode is located on a field effect transistor device such that the arrangement of electrodes and dielectric is in a series circuit relationship with the transistor device.

Within the specification, the term "elastomeric dielectric layer" is used to describe a solid-state dielectric material formed in a layer which is capable of significant elastic compression, preferably in the range of 10 to 25% of the layer thickness.

A transducer embodying this aspect of the present invention is suited to many different applications. For example it may be used in sensing apparatus having features disclosed in our British Patent Application No. 84 07847.

According to another aspect, the present invention provides a sensor for use in article-handling machinery, the sensor comprising an array of discrete capacitative transducers with elastomeric dielectrics, and means to process information signals from the transducers to form a composite representation of the shape of an article being handled.

Thus the sensor can be used in the recognition of an article being held by the machinery, for example by comparing the sensed representation with stored reference shapes; additionally or alternatively it can be used to determine the orientation of an article of a given shape.

The transducers may, for example, be metal-insulator-semiconductor (MIS) capacitors; alternatively they may be metal-insulator-semiconductor field-effect transistors (MISFETs). Each of these two types of device is particularly suited for this application because each type can be manufactured at low cost and in a closely packed arrangement (thereby enabling a good sensing resolution), and provides a continuous output indicative of the amount, rather than the rate, of deformation occurring.

Preferably the sensor has means to store information derived by the transducers, and means to scan the storage means in order to allow sequential transfer of information signals for processing.

In one advantageous form of the invention, the transducers are MISFETs and the sensor incorporates a charge-coupled device, the elastomeric layers of the MISFETs being used as the insulators for the input capacitors of the charge-coupled device itself. Alternatively, the drain currents of the MISFETs are converted to voltages and then fed onto the matrix of the charge-coupled device.

Use of transducers with elastomeric dielectric layers ensures that the transducers have good stress characteristics (whether under tension or compression situations) and provide elastic deformation or compression independent of duration of the force. Thus on the release of stress they can recover their original dimensions fully and rapidly, thereby exhibiting the traits of resilience and low permanent set.

Preferably the elastomeric material for use in the transducers can be applied readily to wafers of, for example, silicon. Thus suitable elastomeric materials include, as examples, silicone rubber, ethylene-propylene rubber, acrylic elastomers, styrene-butadiene rubber and polyurethanes; any of these materials may be in a foamed or in a non-foamed form. The elastomeric material may be applied to the wafer in solution by spin-casting and then crosslinked photolithographically (for example by using ultraviolet-sensitive peroxides).

By a suitable choice of elastomeric material based on its inherent properties and the effect of cross linking, a transducer can be produced with any value, over a wide range, of sensitivity or other operating characteristics.

The elastomeric material forming the transducer dielectric layer is deformable and/or compressible in order to accommodate the change in electrode spacing upon exerting a force. Particularly when the elastomeric material is deformable but not readily compressible, each sensor preferably has provision for some lateral deformation of the material, for example one or more holes in the body of the material; alternatively there may be valleys between adjacent sensors for the displaced elastomeric material when pressure is applied. The elastomeric material can be suitably shaped, for example, by oxygen plasma etching or patterning of the elastomer during crosslinking.

In order that the invention may more readily be understood, a description is now given, by way of example only, reference being made to the accompanying drawings in which:

Figure 1 is a schematic cross-section of a solid-state transducer embodying the present invention;

Figure 2 is a circuit diagram of part of an array of transducers in Figure 1.

The solid-state transducer shown in Figure 1 consists essentially of a field-effect transistor onto which has been applied a MIS capacitative device with an elastomeric dielectric layer.

The FET is formed on a silicon substrate 1 and has a gate 2 which may be a layer of silicon oxide or silicon nitride. On top of the gate 2 is an elastomeric layer 3, 1 m in thickness, of silicon rubber material suitably treated to act as an effective dielectric material. A layer of metal 4 is deposited on top of the elastomeric layer 3 in order to form a gate electrode; in a modification this gate electrode can be formed by a layer of electrically conducting polymer material.

When a force is applied to the transducer in the direction shown by the arrow F, elastomeric layer 3 is compressed so that the separation between layers 2 and 4 is reduced, resulting in an increase in the value of capacitance therebetween; the FET device ensures that the capacitance increase is converted directly to a low output impedance current whose value is an indication of the amount of force applied to the transducer.

A number of such transducers may be arranged in an array in order to form a composite representation of the slope of an article being handled.

Thus, as shown in Figure 2, an array 10 is formed of a number of elastomeric dielectric MISFETs (only a few being shown, namely 11 to 19), each of which can be accessed in order to give an instantaneous value of capacitance, and hence applied force, at that point in the array. Such accessing of each transducer is achieved by activating the respective transistor; the column of the array containing that transistor is energised, and the output of the row containing the same transistor measured. Thus for example, in order to access MISFET 11, the first column of transistors in the array would be energised and only the output of the first row would be measured; the variation in output during energisation would be due to MISFET 11.

In array 10, the transistor sources are connected to ground, while the substrates connect to a suitable constant negative voltage. Each driver (for example 20, 21 or 22) drives a column of transistor gates; each receiver (for example 23, 24 or 25) measures the current drawn by a row of transistor drains. In the quiescent state the driver outputs are all negative, such that the transistors are all turned off, and only leakage currents are measured by the receivers.

When a column of transistors is to be measured, the driver for that column takes the gate voltage to a level where the transistors pass current, the receivers measure the current taken by each transistor in the column, and the individual currents are a measure of the forces applied at each transistor position.

The column drive is a sawtooth voltage, applied to the transistor gate. The receiver is a comparator which switches over when the current drawn by the transistor is equal to that from the constant current source i. By measuring the time t at which the comparator switches, relative to the sawtooth timing, it is simple to deduce the voltage v which causes the transistor to pass the constant current i: that voltage is a measure of the externally applied force.

By measuring and storing the voltage of each transistor when no forces are applied, and subsequently subtracting the stored voltages from normal readings, the array may periodically be zero calibrated. In a similar way, by applying a constant pressure to the array and measuring all the voltages, the absolute sensitivity of each element may be calculated, and suitable compensation made.

In this way a control unit can scan through the entire array 10 and store in a memory the value of applied force corresponding to each point at which a MISFET is situated. Thus a graphic representation of the shape of an article may be formed; if desired, this could be compared with a reference shape in order to recognise the type of article being handled and/or its present orientation.

## CLAIMS

1. A solid-state transducer comprising a field-effect transistor device wherein a layer (3) of an elastomeric dielectric material lies between respective electrode layers (2, 4) of the device, whereby the layer (3) of the elastomeric dielectric material allows a change in the spacing of the electrode layers (2, 4) in response to pressure applied to the device, thereby causing a detectable change in the capacitance of the electrode layers (2, 4).

2. A transducer according to Claim 1 wherein the layer of the elastomeric dielectric material lies between, and adjacent to, the gate electrode (4) and the gate insulator (2) of the field effect transitor device.

3. A transducer according to Claim 1 or Claim 2 wherein said elastomeric dielectric material is selected from the group of materials consisting of silicone rubber, ethylene-propylene rubber, acrylic elastomers, styrene-butadiene rubber and polyurethanes.

4. A transducer according to Claim 3 wherein said elastomeric dielectric material is in the form of a foam.

5. A transducer according to Claim 3 or Claim 4 wherein said elastomeric dielectric material is deposited by spin casting.

6. A sensor suitable for use in article handling machinery, the sensor comprising an array of solid-state transducers each according to any one of Claims 1 to 5 and means (10) to process information signals derived by the transducers to form a composite representation of the shape of an article being handled.

7. A sensor according to Claim 6 wherein said array comprises a plurality of said solid state tranducers arranged in rows and columns, and respective means (20, 21, 22) operating in accordance with a first scanning format are arranged to drive jointly the gates of transducers comprising successive columns (or rows) and further respective means (23, 24, 25), operating in accordance with a second scanning format, are arranged to measure jointly electrical conduction in the source-drain paths of transitors forming successive rows (or columns), wherein said further respective means are capable of supplying said processing means with information representative of a force to which each transistor in the array is subjected.

8. A sensor for use in article-handling machinery, the sensor comprising an array of capacitive transducers with elastomeric dielectrics, and means to process information derived by the transducers to form a composite representation of the shape of an article being handled.

9. A sensor according to Claim 8 wherein the transducers are MIS capacitors.

10. A sensor according to any one of Claims 6 to 9 including means to scan the array in order to allow sequential transfer of information signals for processing.

11. A sensor according to Claim 10 wherein the scanning means is a charge-coupled device.

12. A sensor according to any one of Claims 6 to 11 including means to accommodate the lateral deformation of the elastomeric dielectric material of each transducer.

13. A sensor according to Claim 12 wherein said means accommodating lateral displacement comprises valleys or holes between adjacent transducers in the array.

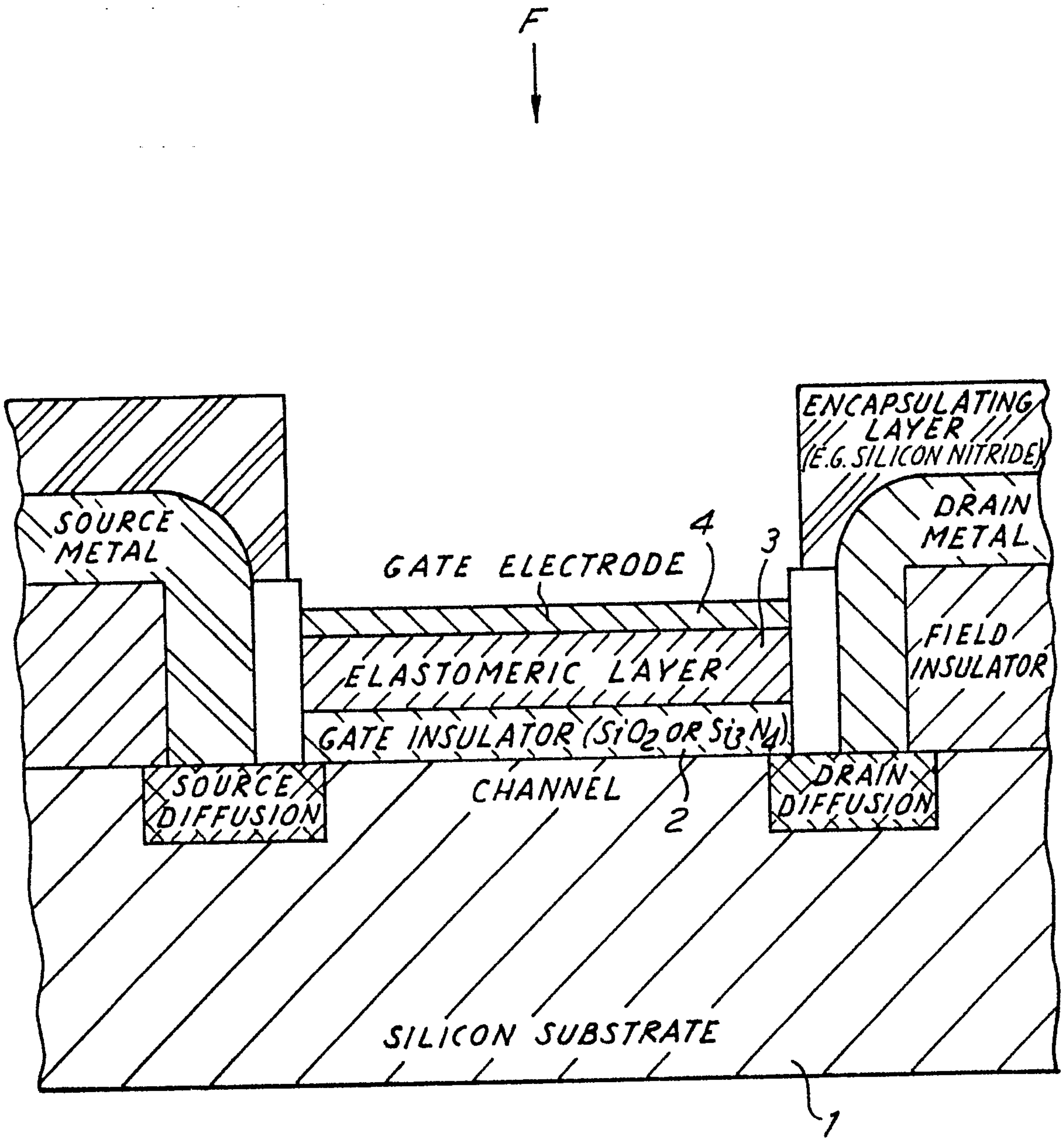
F
ENCAPSULATING LAYER (E.G. SILICON NITRIDE)
SOURCE METAL
DRAIN METAL
GATE ELECTRODE
4
3
FIELD INSULATOR
ELASTOMERIC LAYER
GATE INSULATOR ($SiO_2$ OR $Si_3N_4$)
SOURCE DIFFUSION
CHANNEL
DRAIN DIFFUSION
2
SILICON SUBSTRATE
1

FIG.1

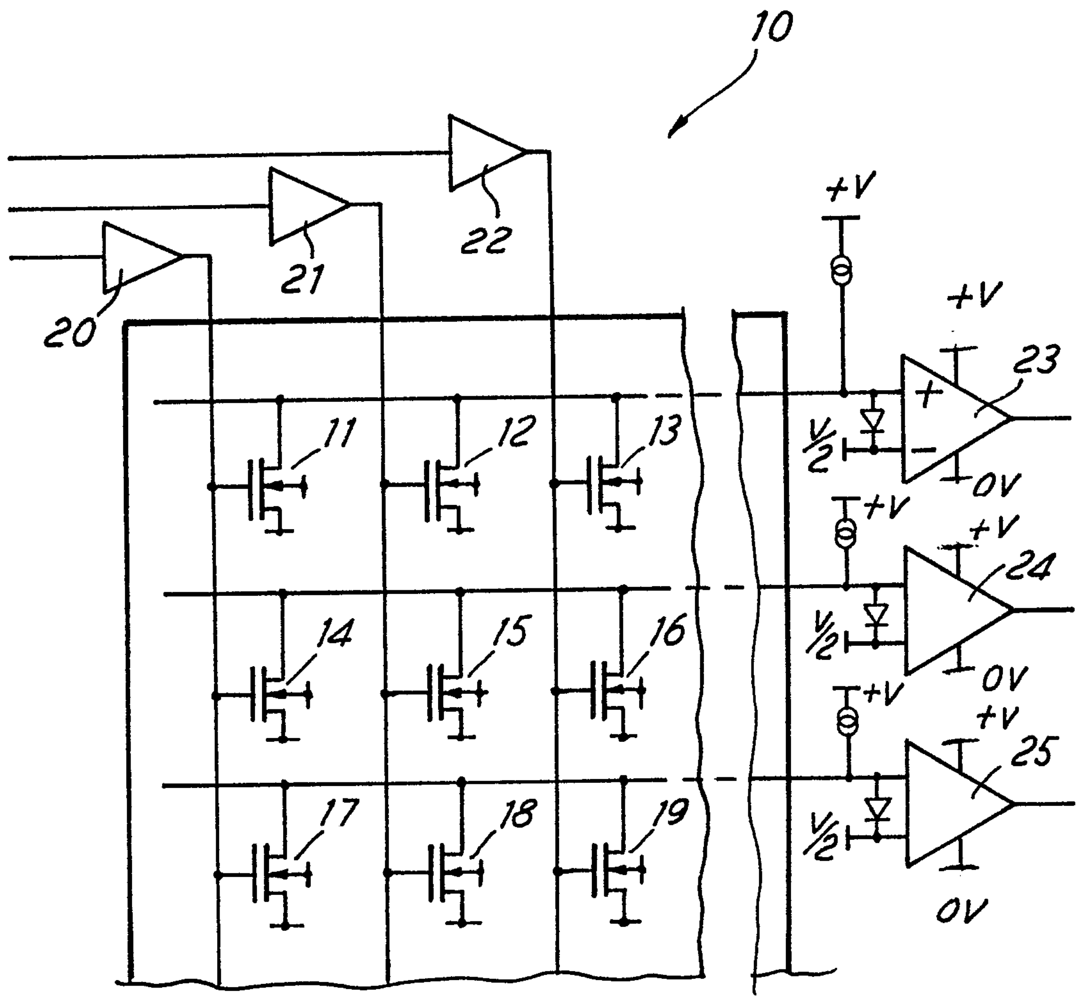
10
20
21
22
+V
+V
23
11
12
13
V/2
OV
+V
+V
24
14
15
16
V/2
OV
+V
+V
25
17
18
19
V/2
OV

FIG.2